## Europäisches Patentamt
## European Patent Office
## Office européen des brevets

(11) Veröffentlichungsnummer: **0 131 879**
**B1**

# (12) EUROPÄISCHE PATENTSCHRIFT

(45) Veröffentlichungstag der Patentschrift:
15.10.86

(51) Int. Cl.⁴: **B 27 N 3/24**

(21) Anmeldenummer: **84107966.8**

(22) Anmeldetag: **07.07.84**

(54) **Doppelbandpresse zur kontinuierlichen Herstellung von Laminaten.**

(30) Priorität: **15.07.83 DE 3325578**

(43) Veröffentlichungstag der Anmeldung:
**23.01.85 Patentblatt 85/4**

(45) Bekanntmachung des Hinweises auf die Patenterteilung:
**15.10.86 Patentblatt 86/42**

(84) Benannte Vertragsstaaten:
**FR GB IT SE**

(56) Entgegenhaltungen:
**DE-A-2 058 820**
**DE-A-2 243 465**
**DE-A-2 421 296**
**DE-A-3 009 770**

(73) Patentinhaber: **Held, Kurt, Alte Strasse 1, D-7218 Trossingen 2 (DE)**

(72) Erfinder: **Held, Kurt, Alte Strasse 1, D-7218 Trossingen 2 (DE)**

(74) Vertreter: **Hoeger, Stellrecht & Partner, Uhlandstrasse 14c, D-7000 Stuttgart 1 (DE)**

EP 0 131 879 B1

LIBER, STOCKHOLM 1986

## Beschreibung

Die Erfindung betrifft eine Doppelbandpresse zur kontinuierlichen Herstellung von Laminaten mit Zwei beheizten, über Walzen umlaufenden Endlosbändern, zwischen deren einander gegenüberliegenden Außenseiten das Laminat geführt wird, mit Heizplatten, die über ringförmig in sich geschlossene Dichtungen an den Innenseiten der Endlosbänder anliegen und mit einem ein Druckkissen bildenden, fluiden Druckmittel in den von den Dichtungen, den Bandinneseiten und den Heizplatten gebildeten Räumen zur Ausübung der erfordelichen Preßkraft auf das Laminat.

Doppelbandpressen dieser Art (DE-OS 24 21 296) dienen insbesondere der Herstellung von dekorativen Schichtstoffleminaten, Spanplatten, Faserplatten, Sperrholzplatten, Elektrolaminaten ("Leiterplatten") und anderen laminierten Werkstoffen. Zur Erzielung einer guten Qualität des Endprodukts ist es erforderlich, während des Durchlaufs des Preßgutes durch die Presse das im Preßgut enthaltene Bindemittel (Kunstharz) unter Druck auszuhärten und die hierfür benötigte Wärmemenge auf das Preßgut zu übertragen. Da die beheizten Endlosbänder nur eine bestimmte Wärmekapazität besitzen, ist die maximal auf das Preßgut zu übertragende Wärmemenge beschränkt und reicht für viele Anwendungsfälle nicht aus. Die Zuführung zusätzlicher Wärme über die Heizplatten und das fluide Druckmittel findet an der schlechten Wärmeleitfähigkeit fluider Medien ihre Grenze.

Zwar ist es bekannt, das Preßgut bereits vor Einlauf in die Doppelbandpresse vorzuheizen, beispielweise durch Infrarotstrahlung. Jedoch kann dies zu einer underwünschten Vorkondensation des im Preßgut enthaltenen Harzes führen, so daß ein Fertigprodukt minderer Qualität entsteht. Weiterhin sind die Energiekosten bei dieser Art der Wärmeübertragung unwirtschaftlich hoch und man kann durch diese Maßnahme kein vorbestimmtes Temperaturgefälle im Preßgut während der Pressung erzeugen, wie es in machen Anwendungsfällen vorteilhaft ist.

Es ist Aufgabe der Erfindung, in einer gattungsgemäßen Doppelbandpresse den Wärmetransport zum Preßgut im Bereich des Druckkissens im Vergleich mit bekannten Anordnungen zu verbessern. Insbesondere soll dabei auch in der durch das Druckkissen begrenzten Reaktionszone des Preßgutes ein Vorbestimmtes Temperaturprofil oder Temperaturgefälle eingestellt werden können.

Die Aufgabe wird erfindungsgemäß dadurch gelöst, daß die mit dem Druckkissen gefüllten Räume zusätzliche Wärmebrücken enthalten, die unter Ausbildung eines guten Wärmeleitkontaktes einerseits mit den Heizplatten verbunden sind und andererseits die Bandinnenseiten schleifend berühren.

Bei einer bevorzugten Ausführungsform der Erfindung können die Wärmebrücken einzeln, in Gruppen oder alle gemeinsam von der Bandinnenseite abgehoben werden, so daß hierdurch eine bestimmte Temperaturverteilung in der Reaktionszone eingestellt werden kann.

Die nachstehende Beschreibung bevorzugter Ausführungsformen der Erfindung dient im Zusammenhang mit beiliegender Zeichnung der weiteren Erläuterung. Es zeigen:

Fig. 1 eine schematische Schnittansicht einer Doppelbandpresse;

Fig. 2 eine Heizplatte der Doppelbandpresse in Untenansicht;

Fig. 3 bis 5 verschiedene Ausführungsformen von Wärmebrücken;

Fig. 6 höhenverstellbare Reinbungsleisten und

Fig. 7 einzeln zu- und abschaltbare Wärmebrücken.

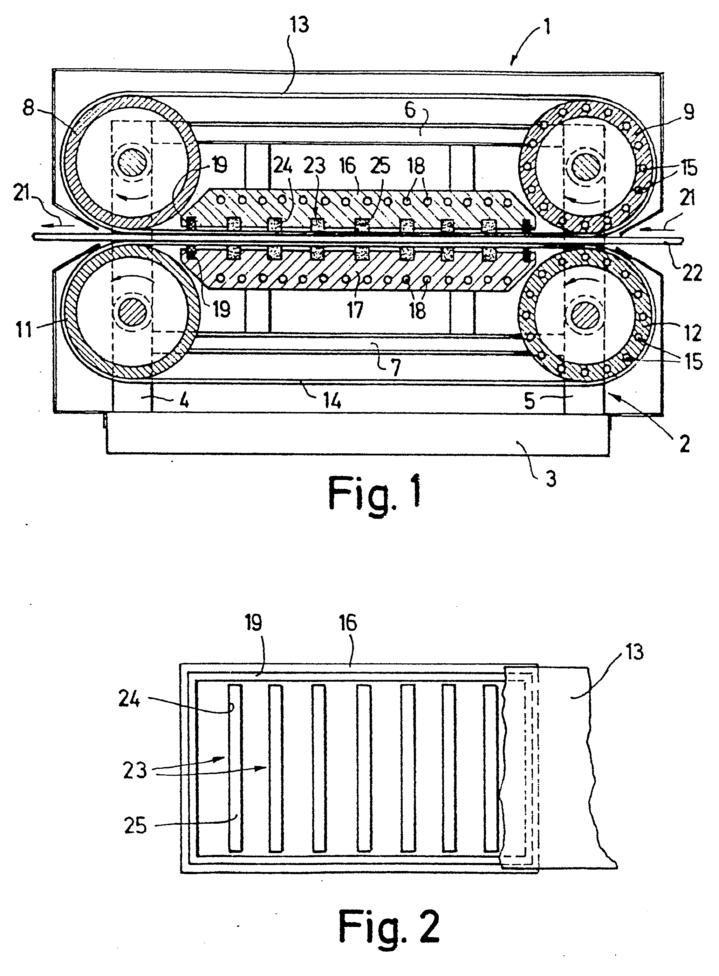

Die in Fig. 1 dargestellte Doppelbandpresse 1 zur kontinuierlichen Herstellung von Laminaten weist ein Maschinengestell 2 auf, welches einen Sockel 3, zwei darauf senkrecht angeordnete Ständer 4, 5 und diese Ständer oben und unten verbindende Holme 6 bzw. 7 umfaßt. Zwischen den Ständern 4, 5 und den Holmen 6, 7 sind vier Walzen 8, 9 und 11, 12 drehbar gelagert. Die Walzen 8, 9 bilden ein oberes, die Walzen 11, 12 ein unteres Walzenpaar. Um jedes Walzenpaar ist ein oberes bzw. unteres Endlosband 13 bzw. 14 herumgeführt und durch nicht dargestellte Mittel gespannt. Die Walzen 8, 11 werden (in an sich bakannter und deshalb nicht dargestellter Weise) in Pfeilrichtung angetrieben. Sie ziehen dabei die Endlosbänder 13 und 14 durch die Presse hindurch, so daß sich deren Außenseiten im Mittelberich der Presse einander gegenüberliegen und mit gleicher Geschwindigkeit parallel zueinander horixontal bewegen. Die beiden anderen Walzen 9, 12 sind in an sich bekannter Weise beheizt, beispielsweise mit Hilfe von Thermoöl, welches in Kanälen 15 im Mantel der Walzen 9, 12 zirkuliert. Die Wärme der Walzen 9 und 12 wird auf die Endlosbänder 13 bzw. 14 übertragen und in die Reaktionszone zwischen diesen Bändern im Mittelbereich der Presse überführt.

Im Mittelberich der Presse sind, abgestützt von den Holmen 6 und 7, Heizplatten 16, 17 angeordnet, die elektrisch oder durch ein strömendes Medium (Thermoöl) beheizt sein können. Das Thermoöl zirkuliert dabei durch Kanäle 18 in den Heizplatten. An ihren einander gegenüberliegenden Seiten sind die Heizplatten 16, 17 mit in sich ringförmig geschlossenen Dichtungen 19 versehen, die an den Platten befestigt sind, an den jeweiligen Innenseiten der in vorgegebenem Abstand parallel zu einander verlaufenden Endlosbänder 13, 14 anliegen und die erwähnte Reaktionszone seitlich begrenzen. Die Reaktionszone wird weiterhin von den Heizplatten 16, 17 begrenzt.

Die Heizplatten 16, 17 liegen über die ringförmigen Dichtungen 19 under Druck an den Innenseiten der Bänder 13, 14 an, so daß in den die Reaktionszone bildenden Raum ein fluides Druckmittel über nicht dargestellte, die Heizplatten druchdrichende Leitungen eingebracht werden kann. Das Druckmittel wird unter einen bestimmten Druck, beispielsweise 20 bar gesetzt und bildet ein Druckkissen, welches auf die Bandinnenseite wirkt und die Bandaußenseite gegen das zu einem Laminat umzuwandelnde, die Presse in Richtung der Pfeile 21 durchlaufende Preßgut 22 andrückt. Das zu Druckmittel kann beispielsweise Luft oder Öl sein. Die Dichtungen 19 liegen dabei unter Druck an den Innenseiten der Endlosbänder 13, 14 an und wirken als Gleitflächendichtung. Die Heizplatten 16, 17 sind auf eine Temperatur aufgeheizt, die höher als die Solltemperatur in der Reaktionszone ist.

Da das erwähnte Fluide Druckmittel ein schlechter Wärmeleiter ist, ist es schwierig, Wärme in ausreichender Menge von den Heizplatten 16, 17 auf die Endlosbänder zu übertragen. Um diese Schwierigkeit zu beheben, sind in den mit den Druckkissen gefüllten Reaktionszonen zusätzliche Wärmebrücken aus gut wärmeleitendem Material angeordnet, die unter Ausbildung eines guten Wärmeleitkontaktes einerseits mit den Heizplatten 16, 17 verbunden sind und andererseits die Innenseiten der Endlosbänder 13, 14 im Bereich der Reaktionszone schleifend berühren. Es wurde gefunden, daß sich hierdurch eine erheblich bessere Wärmeübertragung von den Heizplatten 16, 17 auf die Endlosbänder 13, 14 in der Reaktionszone und von diesen Bändern auf das die Reaktionszone durchlaufende Preßgut 22 erzielen läßt.

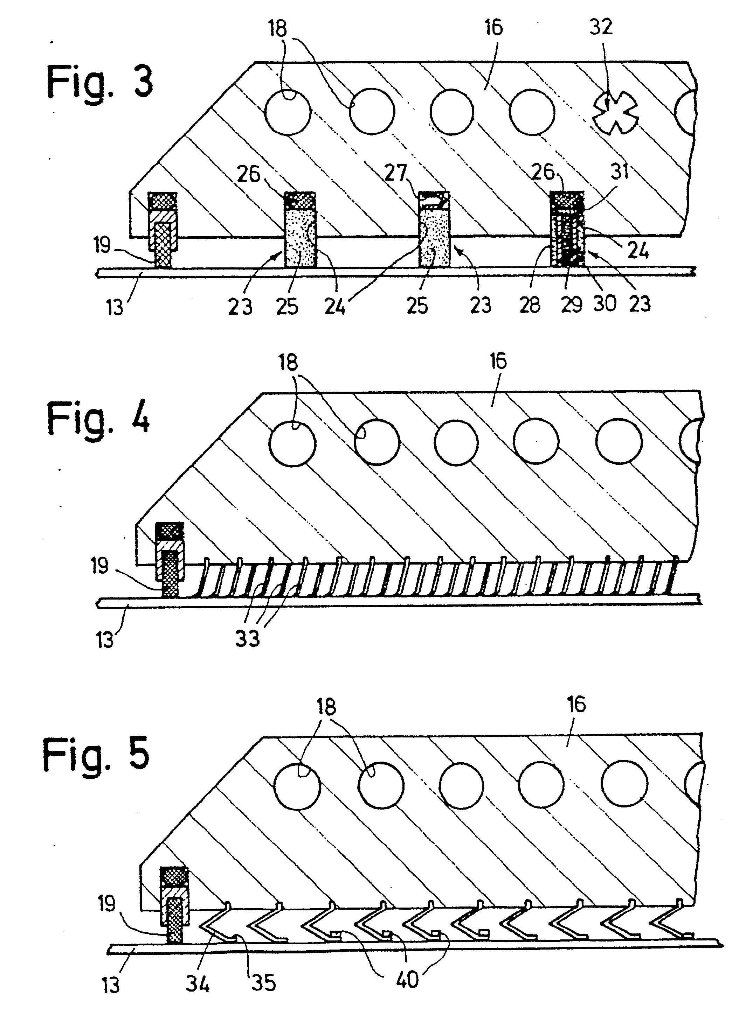

Wie aus Fig. 3 hervorgeht, weist die obere Heizplatte 16 - für die untere Heizplatte 17 gilt entsprechend das Gleiche - an ihrer der Innenseite des Endlosbandes 13 zugekehrten Fläche Nuten 24 auf, in welche die Wärmebrücken 23 zwecks Herstellung eines guten Wärmekontaktes eingefügt sind. Die als Gleitleisten ausgebildeten Wärmebrücken 23 liegen mit ihren den Nuten 24 abgekehrten Flächen am Band 13 an und übertragen auf diese Weise die Wärme von der Heizplatte zum Band.

Die Fig. 3 zeigt drei verschiedene Ausführungsformen von Wärmebrücken 23. Bei der ersten Ausführungsform ist eine Gleitleiste 25 in die Nut 24 vertikal gleitverschieblich eingesetzt. Zwischen der Leiste 25 und dem Grund der Nut 24 befindet sich eine elastische Dichtung 26. Bei der in Fig. 3 in der Mitte dargestellten Ausführungsform ist die Gleitleiste 25 von einem Federprofil 27 belastet, welches die Leiste 25 in gleicher Weise wie die Dichtung 26 gegen das Endlosband 13 drückt. Statt der Nuten 24 können die den Bandinnenseiten zugekehrten Flächen der Heizplatten 16, 17 auch andere Aussparungen, z. B. Bohrungen, aufweisen, in die unter Ausbildung eines guten Wärmeleitkontaktes an den Wärmebrücken 23 befestigte, zu den Aussparungen komplementäre Vorsprünge, z. B. Stifte, vorzugsweise gleitverschieblich eingreifen. Bei der dritten, in Fig. 3 rechts dargestellten Ausführungsform ist die Gleitleiste als U-Profil 28 ausgebildet und enthält einen metallischen, ebenfalls U-förmigen Abstützkern 29. Die Anordnung ist oben von einem Steg 31 abgedeckt, über dem sich wiederum eine elastische Dichtung 26 befindet. Im Abstützkern 29 kann ein weiterer Kern 30 angeordnet sein, der aus elastischem, insbesondere elastomerem Material besteht und das U-Profil 28 mit gutem Wärmeleitkontakt an die Wände der Nut 24 anpreßt.

Die beschriebenen, als Wärmebrücken dienenden Gleitleisten 25, 28 bestehen aus Metall, vorzugsweise einer pulvermetallurgisch gewonnenen Legierung, insbesondere Kupferlegierung, die als poröse Metallmatrix ausgebildet ist und in ihren Poren eingebettet Graphit als Gleitmittel enhält. Der eingebettete Graphit dient zur "Schmierung" der relativ zueinander bewegten Kontaktflächen von Gleitleiste und Endlosband.

Wie weiterhin aus Fig. 3 hervorgeht, können die erwähnten, ein fluides Heizmittel führenden Kanäle 18 in den Heizplatten 16, 17 erfindungsgemäß auch einen von der Kreisform abweichenden Querschnitt besitzen, wie dies unter dem Bezugszeichen 32 dargestellt ist. Wie ersichtlich, weisen die Wände des bei 32 dargestellten Kanals axial verlaufende Vertiefungen und Vorsprünge auf, durch welche die Oberfläche der Kanalinnenwand vergrößert wird und somit eine bessere Wärmeübertragung ergibt. Die Vorsprünge und Vertiefungen können beispielsweise die Form von Nuten oder Riefen und Stegen haben. Hierdurch wird ebenfalls die Wärmeübertragung von den Heizplatten auf die Endlosbänder verbessert.

Bei der in Fig. 4 dargestellten Ausführungsform der Erfindung sind als Wärmebrücken in die Heizplatte 16 borstenartige Elemente 33 aus gut wärmeleitendem Material, vorzugsweise Metall, eingesetzt, die mit ihren freien Ende schleifend an der Innenseite des Bandes 13 anliegen und die Wärme von der Platte 16 in das Band 13 übertragen. Die Borsten können einen runden oder eckigen, insbesondere auch länglichen Querschnitt haben.

Bei der Ausführungsform gemäß Fig. 5 werden als Wärmebrücken Federelemente 34 verwendet, die sich ganz oder teilweise über die Breite der Heizplatte 16 hinweg erstrecken können. Die Federelemente 34 bestehen wiederum aus Metall, vorzugsweise aus einer aushärtbaren Kupfer-Beryllium-Legierung, die neben gutem Wärmeleitvermögen auch gute Gleiteigenschaften besitzt. Die Federelemente 34 liegen unter Federkraft mit abgewinkelten Schenkeln 35 an der Innenseite das Bandes 13 an und vermitteln hierdurch einen guten Wärmeübergang. Auf den Schenkeln 35 können Dauermagnete 40 angeordnet sein, die die Schenkel mit Gleitkontakt gegen die Innenseite des Stahlbandes 13 pressen. In diesem Fall brauchen die Schenkel 35 nicht mit Federkraft an der Bandinnenseite anzuliegen.

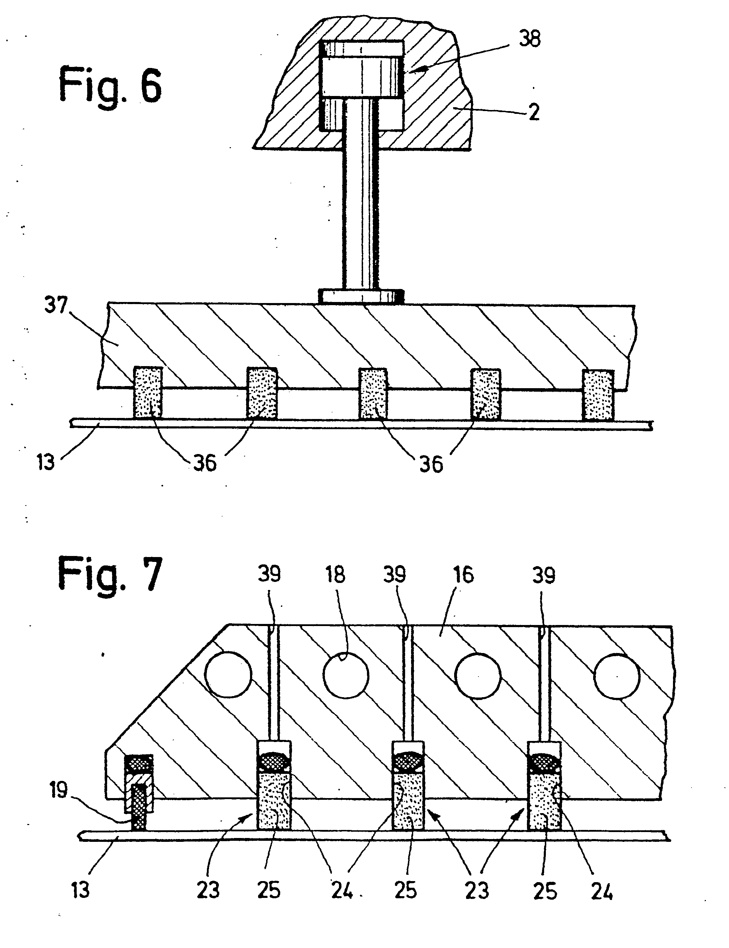

Eine weitere Möglichkeit, zusätzliche Wärme in das die Reaktionszone durchlaufende Preßgut 22 einzubringen, besteht erfindungsgemäß in der Erzeugung von Reibungswärme im Bereich der Reaktionszone. Hierzu werden entsprechend der schematischen Darstellung gemäß Fig. 6 Reibungsleisten 36, die in einer Halterung 37 befestigt sind, im Bereich der Reaktionszonen gegen die Innenseiten der Bänder 13 und 14 angepreßt, so daß in der Kontaktzone Reibungswärme entsteht, welche die Endlosbänder in der Reaktionszone zusätzlich erwärmt. Wie dargestellt, greift an der Halterung 37 ein am Maschinengestell 2 abgestütztes Kolben-Zylinder-Aggregat 38 an, welches den erforderlichen Reibungsdruck liefert. Dieser Druck ist einstellbar und kann auf die zu übertragende Reibungswärmemenge abgestimmt werden.

Die Reibungsleisten 36 bestehen aus einem Material mit nicht zu niedrigem Gleitreibungsbeiwert, insbesondere der oben erwähnten, pulvermetallurgischen Kupferlegierung mit eingebettetem Graphit. Bei der in Fig. 6 dargestellten Ausführungsform dient die mit dem Aggregat 38 erzeugte Preßkraft gleichzeitig neben dem verwendeten fluiden Druckmittel zur Erzeugung des notwendigen Flächendrucks auf das Preßgut 22.

Bei einer anderen Ausgestaltung der Anordnung nach Fig. 6 können die Reibungsleisten 36 gleichzeitig auch die Wärmebrücken sein und zur Übertragung der Wärme aus den Heizplatten 16 auf die Endlosbänder dienen. In diesem Fall wird die Halterung 37 z. B. von den Heizplatten 16, 17 aufgeheizt.

Bei einer anderen Ausführungsform Erfindung, die in Fig. 7 dargestellt ist, werden die Wärmebrücken 23, die so, wie in Fig. 3, 4 und 5 dargestellt, ausgebildet sein können, zu- und abschaltbar ausgebildet, so daß je nach Bedarf und je nach dem gewünschten Ort zusätzliche Wärme in die Reaktionszone eingeleitet werden kann. Wie in Fig. 7 schematisch dargestellt, gehen vom Grund der die Wärmebrücken 23 aufnehemenden Nuten 24 Leitungen 39 aus, die in bekannter Weise mit einem hydraulischen oder pneumatischen Druckmittel beaufschlagbar sind. Auf diese Weise können die in den Nuten 24 gleitbar gehaltenen Wärmebrücken 23 bei entsprechender Druckeinwirkung gegen die Innenseite des Endlosbandes 13 angepreßt werden. Bei Abschaltung des Druckes werden dann die Wärmebrücken 23 unter der Einwirkung des im Druckkissen herrschenden Druckes von dem Endlosband 13 abgehoben, so daß eine Wärmeübertragung nicht mehr stattfindet. Die Wärmebrücken 23 können bei der Anordnung nach Fig. 7 einzeln, in Gruppen oder alle gemeinsam gegen die Bandinnenseite gepreßt bzw. von dieser abgehoben werden. Innerhalb des Druckkissens können (in nicht dargestellter Weise) an sich bekannte Temperaturfühler angeordnet werden, welche die Temperatur der Reaktionszone bereichsweise abfühlen und bereichsweise die Zu- oder Abschaltung der Wärmebrücken über an sich bekannte Steuermittel auslösen. Auf diese Weise kann die Temperatur der Reaktionszone genau kontrolliert und so angepaßt weden, daß die zur Aushärtung des im Preßgut enthaltenen Harzes erforderliche, optimale Wärmemenge zugeführt wird.

Die in Fig. 7 dargestellte Schaltbarkeit der Wärmebrücken 23 läßt sich in entspechender Weise bei weiterer Ausgestaltung der Erfindung auch auf die in Fig. 6 dargestellten Reibungsleisten 36 anwenden.

Bei einer weiteren Ausführungsform der Erfindung können die Wärmebrücken auch als in Bohrungen der Heizplatten 16, 17 gleitend geführte Stifte oder Hülsen aus Metall ausgebildet sein, die in zweckmäßiger Anordnung über die Fläche der Heizplatte verteilt sind. Die Hülsen können dabei axial geschlitzt und federnd ausgebildet sein, so daß sie mit gutem Wärmekontakt in den Bohrungen der Heizplatten anliegen.

**Patentansprüche**

1. Doppelbandpresse (1) zur kontinuierlichen Herstellung von Laminaten (22) mit zwei beheizten, über Walzen umlaufenden Endlosbändern, (13, 14) zwischen deren einander gegenüberliegenden Außenseiten das Laminat geführt wird, mit Heizplatten (16, 17), die über ringförmig in sich geschlossene Dichtungen (19) an den Innenseiten der Endlosbänder anliegen, und mit einem ein Drückkissen bildenden, fluiden Druckmittel in den von den Dichtungen, Bandinnenseiten und Heizplatten gebildeten Räumen zur Ausübung der erforderlichen Preßkraft auf das Preßgut, dadurch gekennzeichnet, daß die mit dem Druckkissen gefüllten Räume zusätzliche Wärmebrücken (23) enhalten, die unter Ausbildung eines guten Wärmeleitkontakts einerseits mit den Heizplatten (16, 17) verbunden sind und andererseits die Bandinnenseiten schleifend berühren.

2. Presse nach Anspruch 1, dadurch gekennzeichnet, daß die den Bandinnenseiten zugekehrten Flächen der Heizplatten (16, 17) Aussparungen aufweisen, in die an den Wärmebrücken (23) befestigte, zu den Aussparungen komplementäre Vorsprünge eingreifen.

3. Presse nach Anspruch 1, dadurch gekennzeichnet, daß die den Bandinnenseiten zugekehrten Flächen der Heizplatten (16, 17) Nuten (24) aufweisen, in die als Wärmebrücken Gleitleisten (25) eingefügt sind, welche ihrerseits mit einer der Nut abgewandten Fläche an der Bandinnenseite anliegen.

4. Presse nach Anspruch 3, dadurch gekennzeichnet, daß die Gleitleisten (25) aus einer Graphit als Gleitmittel enthaltenden Metallmatrix bestehen.

5. Presse nach Anspruch 3 oder 4, dadurch gekennzeichnet, daß die Gleitleisten (28) einen U-förmigen Querschnitt haben.

6. Presse nach Anspruch 5, dadurch gekennzeichnet, daß die U-profilförmigen Gleitleisten (28) von einem elastischen Kern (30) an die Wände der Nut (24) angepreßt sind.

7. Presse nach Anspruch 1, dadurch gekennzeichnet, daß die Wärmebrücken als Borsten (33) ausgebildet sind.

8. Presse nach Anspruch 1, dadurch gekennzeichnet, daß die Wärmebrücken als Federn (34) ausgebildet sind, die durch ihre Federkraft an den Bandinnenseiten anliegen.

9. Presse nach einem der voranstehenden Ansprüche, dadurch gekennzeichnet, daß die Wärmebrücken (35) magnetisch gegen die Bandinnenseiten gedrückt sind.

10. Presse nach einem der voranstehenden Ansprüche, dadurch gekennzeichnet, daß Reibungsleisten (36) vorgesehen sind, die mit solchem Druck an den Bandinnenseiten anliegen, daß im Anliegebereich zusätzliche Reibungswärme im Band (13, 14) entsteht.

11. Presse nach einem der voranstehenden Ansprüche, dadurch gekennzeichnet, daß die Wärmebrücken (23) und/oder Reibungsleisten (36) einzeln, in Gruppen oder alle gemeinsam von der Bandinnenseite abhebbar sind.

12. Presse nach Anspruch 10 oder 11, dadurch gekennzeichnet, daß die Wärmebrücken (23) und/oder Reibungsleisten (36) pneumatisch oder hydraulisch gegen die Bandinnenseiten gepreßt und/oder von diesen abhebbar sind.

13. Presse nach einem der voranstehenden Ansprüche, dadurch gekennzeichnet, daß die Heizplatte (16, 17) Kanäle (32) zur Aufnahme eines strömenden Heizmediums aufweist und die Wände der Kanäle durch Vertiefungen oder Vorsprünge zwecks besserer Wärmeübertragung eine vergrößerte Oberfläche haben.

**Claims**

1. Double belt press (1) for the continuous manufacture of laminates (22) and with, passing over rollers, two heated endless belts (13, 14) between whose oppositely disposed outer faces the laminate is passed and having heating panels (16, 17) which bear on the inside faces of the endless belts through annularly self-contained seals (19), and with, forming a pressure cushion, a fluid pressurised medium in the spaces formed by the seals, the inside faces of the belts and the heating panels, so that the necessary pressure can be applied to the material to be rolled out, characterised in that the spaces filled with the pressure cushions contain additional heat bridges (23) which, while establishing a good heat conduction contact, are on the one hand connected to the heating panels (16, 17) while on the other they provide a friction contact with the inside faces of the belts.

2. Press according to Claim 1, characterised in that the faces of the heating panels (16, 17) which are towards the inside faces of the belts comprise recesses engaged by projections complementary with the recesses and mounted on the heat bridges (23).

3. Press according to Claim 1, characterised in that the faces of the heating panels (16, 17) which are towards the inside faces of the belts comprise grooves (24) into which there are inserted to form heat bridges sliding strips (25) which have bearing on the inside face of the belt a surface remote from the grooves.

4. Press according to Claim 3, characterised in that the sliding strips (25) consist of a graphite as a metal matrix containing a sliding or lubricating medium.

5. Press according to Claim 3 or 4, characterised in that the sliding strips (28) are of U-shaped cross-section.

6. Press according to Claim 5, characterised in that the sliding strips (28) which are of U-shaped cross-section are pressed against the walls of the groove (24) by an elastic core (30).

7. Press according to Claim 1, characterised in that the heat bridges are constructed as bristles (33).

8. Press according to Claim 1, characterised in that the heat bridges are constructed as springs (34) whose spring force maintains them applied against the inside faces of the belt.

9. Press according to one of the preceding Claims, characterised in that the heat bridges (35) are pressed magnetically against the inside faces of the belt.

10. Press according to one of the preceding Claims, characterised in that friction strips (36) are provided which bear with such pressure on the inside faces of the belt that in the area to which they are applied additional frictional heat is created in the belt (13, 14).

11. Press according to one of the preceding Claims, characterised in that the heat bridges (23) and/or friction strips (36) can be lifted off the inside face of the belt individually, in groups or all at the same time.

12. Press according to Claim 10 or 11, characterised in that the heat bridges (23) and/or friction strips (36) are pressed against and/or lifted off the inside faces of the belt pneumatically or hydraulically.

13. Press according to one of the preceding Claims, characterised in that the heating panel (16, 17) comprises passages (32) to accommodate a flowing heating medium, the walls of the passages being provided with depressions or projections to afford an enlarged surface area for improved heat transference.

## Revendications

1. Presse à double bande (1) pour la fabrication en continu de stratifiés (22), à deux bandes sans fin (13, 14) chauffées, tournant autour de cylindres, entre les faces extérieures opposées l'une à l'autre desquelles est guidé le stratifié, avec des plaques chauffantes (16, 17) qui sont appliquées contre les faces intérieures des bandes sans fin par l'intermédiaire de joints d'étanchéité (19) annulaires fermés sur eux-mêmes, avec un fluide de pression servant de coussin de pression dans les volumes limités par les joints d'étanchéité, les faces intérieures des bandes et les plaques chauffantes, afin d'exercer la force de pression nécessaire sur la matière pressée, caractérisée en ce que les volumes remplis par le coussin de pression contiennent en plus des ponts thermiques (23) qui, en créant un bon contact de conduction thermique, sont, d'une part reliés aux plaques chauffantes (16, 17) et, d'autre part, sont en contact de frottement avec les faces intérieures des bandes.

2. Presse selon la revendication 1 caractérisée en ce que les surfaces des plaques chauffantes (16, 17) tournées vers les faces intérieures des bandes présentent des évidements dans lesquels s'engagent des saillies fixées aux ponts thermiques et complémentaires à ces évidements.

3. Presse selon la revendication 1, caractérisée en ce que les surfaces des plaques chauffantes (16, 17) tournées vers les faces intérieures des bandes présentent des rainures (24) dans lesquelles sont introduites comme ponts thermiques des baguettes de glissement (25) qui sont, de leur côté, appliquées contre les faces intérieures des bandes par une surface située à l'opposé de la rainure.

4. Presse selon la revendication 3, caractérisée en ce que les baguettes de glissement (25) sont constituées par une matrice en métal contenant du graphite comme moyen de glissement.

5. Presse selon la revendication 3 ou 4, caractérisée en ce que les baguettes de glissement (28) ont une section droite en U.

6. Presse selon la revendication 5, caractérisée en ce que les baguettes de glissement à profil en U (28) sont serrées contre les parois de la rainure (24) par un noyau (30) élastique.

7. Presse selon la revendication 1, caractérisée en ce que les ponts thermiques sont analogues à des poils de brosse (33).

8. Presse selon la revendication 1, caractérisée en ce que les ponts thermiques sont constitués par des ressorts qui s'appliquent contre les faces intérieures des bandes sous l'effet de leur élasticité.

9. Presse selon l'une quelconque des revendications précédentes, caractérisée en ce que les ponts thermiques (35) sont serrés par effet magnétique contre les faces intérieures des bandes.

10. Presse selon l'une quelconque des revendications précédentes, caractérisée en ce qu'il est prévu des baguettes de friction (36) qui sont appliquées contre les faces intérieures des bandes avec une pression telle qu'il se produit dans la zone de contact une chaleur de friction supplémentaire dans les bandes (13, 14).

11. Presse selon l'une quelconque des revendications précédentes, caractérisée en ce que les ponts thermiques (23) et/ou les baguettes de friction (36) peuvent être éloignés de la face intérieure de la bande soit individuellement, soit par groupes, soit tous ensemble.

12. Presse selon la revendication 10 ou 11, caractérisée en ce que les ponts thermiques (23) et/ou les baguettes de friction (36) peuvent être serrés pneumatiquement ou hydrauliquement contre les faces intérieures des bandes et/ou être éloignés de ces faces.

13. Presse selon l'une quelconque des revendications précédentes, caractérisée en ce que les plaques chauffantes (16, 17) présentent des canaux (32) destinés à recevoir un fluide de chauffage en circulation et les parois de ces canaux ont une surface agrandie par des dépressions ou des saillies en vue d'une amélioration de la transmission de la chaleur.

Fig. 1

Fig. 2

**Fig. 3**

**Fig. 4**

**Fig. 5**

Fig. 6

Fig. 7